# EUROPEAN PATENT APPLICATION

(11) **EP 2 067 800 A1**
(43) Date of publication of application: **10.06.2009**
(21) Application number: 07828702.6
(22) Date of filing: 28.09.2007
(51) Int. Cl.: C08F 290/14, G02B 1/04, G03F 7/027, G03F 7/075, C08G 77/20

(54) **POLYORGANOSILOXANE COMPOSITION**

(30) Priority: 29.09.2006 JP 2006267045; 02.11.2006 JP 2006298506
(71) Applicant: Asahi Kasei Corporation, Tokyo 101-8101 (JP)
(72) Inventor: KIMURA, Masashi, Tokyo 100-8440 (JP); MIKAWA, Masato, Tokyo 100-8440 (JP); FUJIYAMA, Hideyuki, Tokyo 100-8440 (JP); KOBAYASHI, Takaaki, Tokyo 100-8440 (JP); YORISUE, Tomohiro, Tokyo 100-8440 (JP)
(74) Representative: Strehl Schübel-Hopf & Partner
(86) International application number: PCT/JP2007/068961
(87) International publication number: WO 2008/041630

(57) **Abstract**

Disclosed is a polyorganosiloxane composition containing the following components (a)-(c). (a) 100 parts by mass of a polyorganosiloxane obtained by mixing at least one silanol compound represented by the general formula (1) below, at least one alkoxysilane compound represented by the general formula (2) below, and at least one catalyst selected from the group consisting of compounds represented by the general formula (3) below, compounds represented by the general formula (4) below and Ba(OH)₂, and polymerizing the mixture without actively adding water thereinto [chemical formula 1] R₂Si(OH)₂ (1) [chemical formula 2] R'Si(OR")₃ (2) (chemical formula 3] M(OR''')₄ (3) [chemical formula 4] M'(OR'''')₃ (4) (b) 0.1-20 parts by mass of a photopolymerization initiator (c) 1-100 parts by mass of a compound other than the component (a) having two or more photopolymerizable unsaturated bonding groups.

## Description

### TECHNICAL FIELD

The present invention relates to a resin composition used for insulating materials of electronic components, for formation of surface protecting films, interlayer insulating films, α-ray shielding films and the like in semiconductor devices, and for semiconductor devices and the like mounting image sensors, micromachines or microactuators, and to a semiconductor device and the like manufactured using the resin composition. Particularly, the present invention relates to a novel polyorganosiloxane composition which is excellent in photosensitive characteristic under the UV-i line, can be cured at a low temperature of 250°C or less, has a very small volume shrinkage in the heat curing process, further has an excellent transparency and a low degassing property achieved at a high level in a resin structure and a resin film after heat curing, and further, if required, can be made tack free in a coated film after soft-baking, and to a semiconductor device and the like manufactured using the polyorganosiloxane composition.

### BACKGROUND ART

For applications such as insulating materials of electronic components, and surface protecting films, interlayer insulating films and α-ray shielding films of semiconductor devices, polyimide resins concurrently having excellent heat resistance, electric characteristics and mechanical characteristics are extensively used. The polyimide resin is **characterized in that** it is usually supplied in a form of a photosensitive polyimide precursor composition, applied on a base, subjected to soft-baking, irradiated with (exposed to) active rays through a desired patterning mask, developed, and subjected to a heat curing to easily form a cured relief pattern composed of a heat resistant polyimide resin (for example, see Patent Document 1).
In recent years, there have been increased demands for a material which can be heat cured at a lower temperature in the manufacturing process of semiconductor devices, mainly for reasons of materials of constituent elements and the structural designs. However, in the case of conventional polyimide resin precursor compositions, if the curing temperature is reduced, thermal imidization cannot be completed and various physical properties of the cured film are reduced, so the lower limit of the curing temperature is about 300°C at most.

In the recent design concept of semiconductor devices, attempts have been made to increase the cross-sections of interconnects at necessary places, for reducing the electric resistance, and resistive noises and resistive heat generation involved therein in addition to the conventional tendency of multilayer high-densification. Particularly if a "giant interconnect" layer of 10 µm or more in thickness is coated with a conventional polyimide precursor composition, which is heat-cured, the volume shrinkage of as much as about 40% occurs mainly due to volatilization of remaining solvent components, causing large differences between levels on the "giant interconnect" and in the vicinity thereof, and therefore, demands for a material capable of being coated more uniformly and evenly are high.

Patent Document 2 discloses a photosensitive siloxane material which can be cured at a low temperature and has little volume shrinkage in the heat curing process, but only the technology disclosed therein alone can hardly achieve performances, such as adhesiveness to an underlying base material and practical-level mechanical properties, enough to stably form surface protecting films, interlayer insulating films and α-ray shielding films of electronic components and semiconductor devices.

Further, even if the material disclosed in Patent Document 2 is coated on a base and thereafter subjected to soft-baking as performed for conventional polyimide precursor compositions, the resultant coated film keeps tackiness and fluidity. Therefore, new constraints on processes are undeniably created, such as a risk of device contamination by the contact of coated base with devices during transportation, and necessity of keeping the base always horizontal for preventing flow of coated films on the base.

That is, no photosensitive film-forming material which is excellent in low-temperature curability, has a small volume shrinkage during curing, and has practical performances capable of substituting for conventional polyimide precursors is yet found at present.

On the other hand, semiconductor devices mounting elements having optical functions and mechanical functions in integrated circuits or otherwise are put into practical use. Many of them are manufactured by forming elements, such as transistors, on crystal substrates such as silicon substrates using conventionally well-known semiconductor processes, thereafter forming elements (microstructures) having functions for purposes of semiconductor devices, and packaging them as one package.

As an example of such a packaging technology, for example, in Patent Document 3, a semiconductor device and its examples are disclosed in detail, which device has a microstructure formed on a crystal substrate on which integrated circuits are formed, a packaging material to cover the microstructure, and a spacer to support the packaging material on the microstructure. The technology disclosed in Patent Document 3 can be used suitably for various types of sensors such as microlens arrays and chemical sensors and for a wide range of semiconductor devices such as surface acoustic wave devices; however, for carrying out the invention described in Patent Document 3, the spacer to support the packaging material on the microstructure plays an important role. The characteristics required for the spacer are considered to be the following three points.

First, since the spacer must be formed only in portions necessary for a support, the spacer itself is advantageously formed of a member having photosensitivity. This is because if the spacer itself has photosensitivity, an etching process can be eliminated out of a lithography process and an etching process usually used for leaving a spacer only in necessary portions.

A member having a low heat resistance, for example, an adhesive such as an epoxy resin, is used on the periphery of the spacer, and besides, a microstructure located thereunder does not necessarily have a high heat resistance. Therefore, secondly, a lower temperature of a process to form the spacer can be said to be more preferable.

Thirdly, since the spacer forms a closed space containing a microstructure, if quoting from the description in Patent Document 3, forms a "cavity", remaining of volatile components and the like contained in the spacer after completion of packaging is not preferable. That is, the spacer is required to be highly volatile components.

The characteristics as described above are considered to be required for a spacer, but in Patent Document 3, no particular member used suitably for a spacer is disclosed.
Patent Document 1: Japanese Patent No. 2826940
Patent Document 2: EP Patent No. 1196478
Patent Document 3: JP-A-2003-516634

### DISCLOSURE OF THE INVENTION

### PROBLEMS TO BE SOLVED BY THE INVENTION

It is an object of the present invention to provide a novel polyorganosiloxane composition which meets recent years' requirements for a resin composition used for insulating materials of electronic components and formation of surface protecting films, interlayer insulating films, α-ray shielding films and the like in semiconductor devices, and semiconductor devices and the like mounting image sensors, micromachines or microactuators, namely a novel polyorganosiloxane composition which is excellent in photosensitive characteristic under the UV-i line, can be cured at a low temperature of 250°C or less, has a very small volume shrinkage in this heat curing process, further has an excellent transparency and a low degassing property achieved at a high level in a resin structure and a resin film after heat curing, and further, if desired, can be made tack free in a coated film after soft-baking.

### MEANS FOR SOLVING THE PROBLEMS

A first aspect of the present invention is a composition containing the following components (a) to (c):
(a) 100 parts by mass of a polyorganosiloxane obtained by mixing and polymerizing at least one silanol compound represented by the general formula (1) shown below, at least one alkoxysilane compound represented by the general formula (2) shown below, and at least one catalyst, said catalyst selected from the group consisting of a metal alkoxide represented by the general formula (3) shown below, a metal alkoxide represented by the general formula (4) shown below, and Ba(OH)₂, without purposely adding water,

R₂Si(OH)₂ (1)

R'Si(OR")₃ (2)

where R is a group having 6 to 20 carbon atoms containing at least one aromatic group; R' is an organic group having 2 to 17 carbon atoms containing at least one group selected from the group consisting of an epoxy group and a carbon-carbon double bond group; and R" is a methyl group or an ethyl group,

M(OR"')₄ (3)

where M denotes any one of silicon, germanium, titanium and zirconium; and R"' is an alkyl group having 1 to 4 carbon atoms,

M'(OR"")₃ (4)

where M' denotes boron or aluminum; and R"" is an alkyl group having 1 to 4 carbon atoms;
(b) 0.1 to 20 parts by mass of a photopolymerization initiator; and
(c) 1 to 100 parts by mass of a compound, other than the component (a), having two or more photopolymerizable unsaturated bond groups.

The composition according to the first aspect of the present invention is preferable, wherein the composition further contains as an adherence agent (e), 0.1 to 20 parts by mass of at least one organosilicon compound selected from the group consisting of (CH₃O)₃-Si-(CH₂)₃-O-CO-C(CH₃)=CH₂, (CH₃O)₃-Si-(CH₂)₃-O-CO-CH=CH₂ and (CH₃O)₃-Si-(CH₂)₃-O-CH₂-C₂H₃O (the afore-mentioned C₂H₃O being an epoxy group) based on 100 parts by mass of the component (a).

The composition according to the first aspect of the present invention is preferable, wherein the above-mentioned catalyst is at least one metal alkoxide selected from the group consisting of a metal alkoxide represented by the general formula (3) shown above and a metal alkoxide represented by the general formula (4) shown above.

The composition according to the first aspect of the present invention is preferable, wherein the polyorganosiloxane (a) is obtained by mixing the silanol compound described above, the alkoxysilane compound described above, the catalyst described above, potassium hydroxide and sodium hydroxide and polymerizing without purposely adding water.

Further, the composition according to the first aspect of the present invention is preferable, wherein the composition contains 50 to 200 parts by mass of (d) a silicone resin based on 100 parts by mass of the component (a).

A second aspect of the present invention is a process for manufacturing a microplastic lens or an optical element for a liquid crystal sheet polarizer, wherein the method sequentially performs the steps of: coating the composition according to the first aspect of the present invention on a glass substrate, and heating the coated substrate at 50 to 150°C for 1 to 30 min to obtain a composition-adhered glass substrate; pressing an opening portion of a mold for moldings in which a separately prepared composition according to the first aspect of the present invention is filled, against the composition-adhered surface of the composition-adhered glass substrate; exposing the resultant pressed substrate from the glass substrate side to light; stripping the mold for moldings from the glass substrate; and heating the resultant stripped substrate at a temperature of 150°C to 250°C for 0.5 hour to 2 hours.

A third aspect of the present invention is a process for manufacturing a microplastic lens, wherein a method sequentially performs the steps of: coating a composition according to the first aspect of the present invention on a glass substrate or a silicon substrate, and heating the coated substrate at 50 to 150°C for 1 to 30 min to obtain a composition-adhered glass substrate or silicon substrate; exposing plural times the resultant composition-adhered substrate to ultraviolet rays using a plurality of masks composed of circular patterns of a microplastic lens, each mask having an alignment mark and each lens pattern having a concentric circular pattern of a different diameter, and through every mask sequentially starting from a mask of the smallest circular diameter at a constant exposure level of a remaining-film saturated minimum exposure level after development etching divided by the number of the masks; and developing the resultant substrate after the exposure; and heating the resultant substrate at a temperature of 150°C to 250°C for 0.5 hour to 2 hours after the development.

A fourth aspect of the present invention is a method of forming a polyorganosiloxane film, characterized by coating a composition according to the first aspect of the present invention onto a base.

A fifth aspect of the present invention is a polyorganosiloxane cured film, **characterized in that** the film is obtained by curing a polyorganosiloxane film obtained by a method according to the fourth aspect of the present invention, by at least one method selected from the group consisting of irradiation with active light ray and heating.

A sixth aspect of the present invention is a process for forming a polyorganosiloxane cured relief pattern, wherein the method comprises the steps of: forming a polyorganosiloxane film on a base having a metal interconnection or a base having no metal interconnection by a method according to the fourth aspect of the present invention; irradiating the film with active light ray through a patterning mask to photocure an exposed portion; removing an uncured portion of the film using a developing solution; and heating the resultant film together with the base.

A seventh aspect of the present invention is a polyorganosiloxane cured relief pattern obtained using a method according to the sixth aspect of the present invention.

An eighth aspect of the present invention is a semiconductor device including a cured film according to the fifth aspect of the present invention.

A ninth aspect of the present invention is a semiconductor device including a cured relief pattern according to the seventh aspect of the present invention.

A tenth aspect of the present invention is a semiconductor device having a microstructure formed on a crystal substrate on which an integrated circuit is formed, a packaging material to cover the microstructure and a spacer material to support the packaging material on the microstructure, **characterized in that** the spacer is a cured film according to the fifth aspect of the present invention.

An eleventh aspect of the present invention is a semiconductor device according to the tenth aspect of the present invention, **characterized in that** the integrated circuit contains a photodiode.

A twelfth aspect of the present invention is a semiconductor device according to the tenth or eleventh aspect of the present invention, **characterized in that** the microstructure is a microlens.

A thirteenth aspect of the present invention is a process for manufacturing a semiconductor device according to any one of the tenth to twelfth aspects of the present invention, wherein the method comprises the steps of: forming a polyorganosiloxane film on a microstructure directly or through a thin film layer; irradiating the film with active light ray through a patterning mask to photocure an exposed portion; removing an uncured portion of the film using a developing solution; and heating the film together with a base.

### ADVANTAGES OF THE INVENTION

The composition of the present invention is excellent in photosensitive characteristic under the UV-i line, can be cured at a low temperature of 250°C or less, and can reduce remarkably the volume shrinkage during the heat curing process. The method of forming a cured relief pattern of the present invention can form easily a cured relief pattern capable of accomplishing an excellent transparency and a low degassing property at high levels. The method of manufacturing a semiconductor device of the present invention can manufacture a semiconductor device having a cured relief pattern accomplishing simultaneously an excellent transparency, a high heat resistance and a low degassing property.

### BRIEF DESCRIPTION OF THE DRAWING

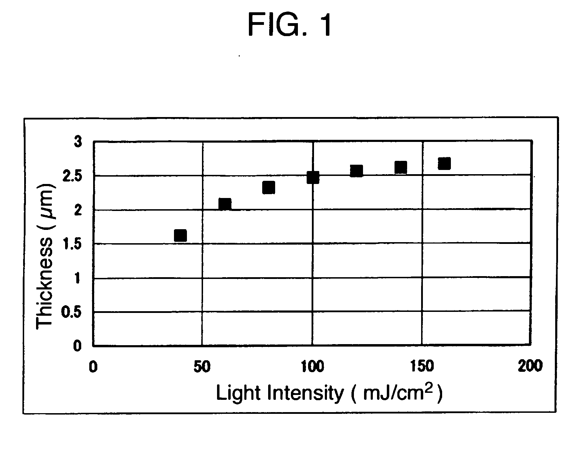

Fig. 1 is a diagram showing the correlation between exposure set values in an exposing apparatus and remaining-film thicknesses after the development.

### BEST MODE FOR CARRYING OUT THE INVENTION

Now, each component constituting the composition of the present invention will be particularly described.

### (a) Polyorganosiloxanes

Polyorganosiloxanes used in the composition of the present invention are obtained by a method in which at least one of silanol compounds represented by the general formula (1) shown below, at least one of alkoxysilane compounds represented by the general formula (2) shown below, and at least one of catalysts represented by the general formula (3) shown below are mixed and polymerized without purposely adding water,

R₂Si(OH)₂ (1)

R'Si(OR")₃ (2)

where R is a group having 6 to 20 carbon atoms containing at least one aromatic group; R' is an organic group having 2 to 17 carbon atoms containing at least one group selected from the group consisting of epoxy groups and carbon-carbon double bond groups; and R" is a methyl group or an ethyl group,

M(OR"')₄ (3)

where M denotes any one of silicon, germanium, titanium and zirconium; and R"' is an alkyl group having 1 to 4 carbon atoms.
Herein, all or a part of the catalyst(s) represented by the general formula (3) shown above may be replaced with at least one catalyst represented by the general formula (4) shown below,

M'(OR"")₃ (4)

where M' denotes boron or aluminum; and R"" is an alkyl group having 1 to 4 carbon atoms.
All or a part of the catalyst(s) represented by the general formula (3) shown above may be replaced with Ba(OH)₂.

Particularly, the catalyst described above is preferably at least one metal alkoxide selected from the group consisting of the general formula (3) and the general formula (4).

Further, in the process of polymerizing a polyorganosiloxane without purposely adding water, as the catalyst, at least one alkaline metal hydroxide selected from the group consisting of potassium hydroxide and sodium hydroxide may be used.

In a silanol compound represented by the general formula (1) shown above, R is a group having 6 to 20 carbon atoms containing at least one aromatic group. Particularly, the group is preferably at least one group selected from the groups represented by the structural formulas below.

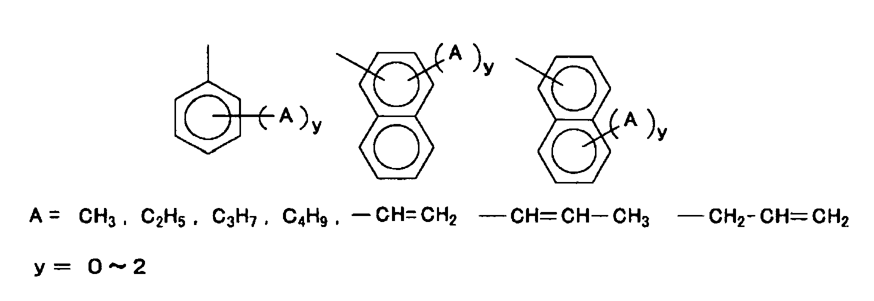

In an alkoxysilane compound represented by the general formula (2) shown above, R' includes at least one group selected from the group consisting of groups having 2 to 17 carbon atoms and containing at least one of epoxy groups and carbon-carbon double bond groups. R" is a methyl group or an ethyl group. A particular example of R' is preferably at least one group selected from groups represented by the following structural formulas.

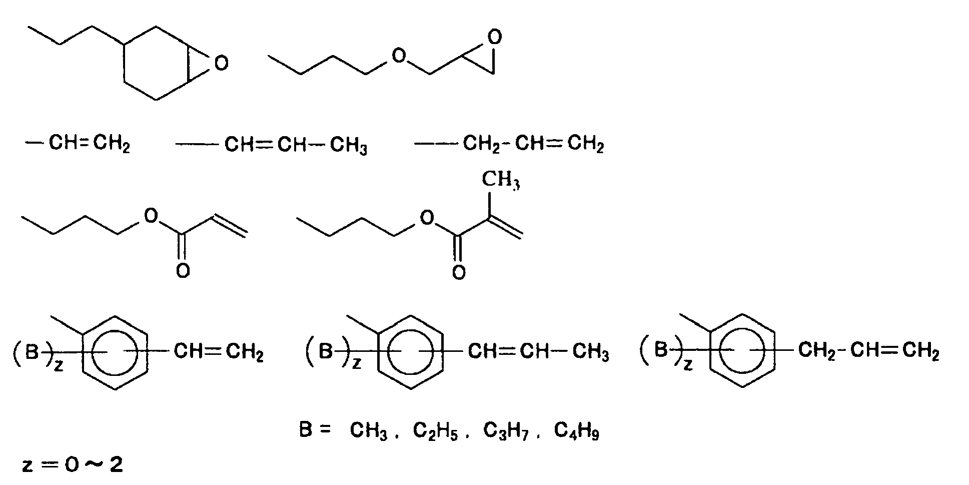

The polyorganosiloxane of the present invention is obtained by a method in which at least one of silanol compounds represented by the general formula (1) shown above, at least one of alkoxysilane compounds represented by the general formula (2) shown above, and at least one of catalysts selected from the group consisting of groups represented by the general formula (3) shown above, the general formula (4) shown above and Ba(OH)₂ are mixed and polymerized without purposely adding water.

While a metal alkoxide represented by the general formula (3) shown above and the general formula (4) shown above catalyzes dealcoholization condensation reaction of a silanol compound (silanol group) with an alkoxysilane compound (alkoxysilyl group), it also acts itself as an alkoxy group-containing compound, and is involved in the dealcoholization condensation reaction to form a polysiloxane or polysilsesquioxane structure in a form incorporated in molecules.

With respect to the mixing ratio, the silanol compound and the alkoxysilane compound of the present invention are mixed basically in 1:1, and the alkoxysilane compound may be mixed in a proportion of 30 to 70 mol to 50 mol of the silanol compound. Here, when the metal alkoxide of the present invention is mixed, the whole mixing ratio is preferably adjusted by replacing a part of the alkoxysilane compound with the metal alkoxide (the mixing amount of the alkoxysilane compound is decreased by a certain ratio).

Specifically, when a tetravalent metal alkoxide represented by the general formula (3) of the present invention is used as a metal alkoxide, the amounts of the tetravalent metal alkoxide used and the alkoxysilane compound replaced are preferably in a 1:2 molar ratio (on every 1-mol increase of the mixing amount of the tetravalent metal alkoxide, the alkoxysilane compound is decreased by 2 mols.). When a trivalent metal alkoxide represented by the general formula (4) of the present invention is used, the amounts of the trivalent metal alkoxide used and the alkoxysilane compound replaced are preferably in a 2:3 molar ratio.

The catalyst is used under the conditions of a temperature of 40°C to 150°C (inclusive) for 0.1 to 10 hours, and among other catalysts, Ti(O-CH(CH₃)₂)₄ is preferably used in view of the transparency of an obtained liquid resin. The addition amount of the catalyst is preferably 1 to 10 mol% and more preferably 1 to 3 mol%, to the total mol% of a and b.

A product obtained by the step of hydrolyzing compounds containing a and b described above in the presence of 0% water at a temperature of 75 to 85°C for 30 min to 1 hour is available as ORMOCER® ONE from Fraunhofer ISC in Germany.

Silanol compounds preferable for the present invention include diphenylsilanediol, di-p-toluylsilanediol, di-p-styrylsilanediol and dinaphthylsilanediol, but diphenylsilanediol is most preferable in view of cost, availability, copolymerization, heat resistance and the like.

Alkoxysilane compounds preferable for the present invention include 2-(3,4-epoxycyclohexyl)ethyltrimethoxysilane, 2-(3,4-epoxycyclohexyl)ethyltriethoxysilane, 3-glycidoxypropyltrimethoxysilane, 3-glycidoxypropyltriethoxysilane, vinyltrimetoxysilane, vinyltriethoxysilane, 1-propenyltrimethoxysilane, 1-propenyltriethoxysilane, 2-propenyltrimethoxysilane, 2-propenyltriethoxysilane, 3-methacryloyloxypropyltrimethoxysilane, 3-methacryloyloxypropyltriethoxysilane, 3-acryloyloxypropyltrimethoxysilane, 3-acryloyloxypropyltriethoxysilane, p-styryltrimethoxysilane, p-styryltriethoxysilane, p-(1-propenylphenyl)trimethoxysilane, p-(1-propenylphenyl)triethoxysilane, p-(2-propenylphenyl)trimethoxysilane and p-(2-propenylphenyl)triethoxysilane, but to obtain excellent UV-i line photosensitive characteristics, 3-methacryloyloxypropyltrimethoxysilane, 3-methacryloyloxypropyltriethoxysilane, 3-acryloyloxypropyltrimethoxysilane and 3-acryloyloxypropyltriethoxysilane, which have a photopolymerizable carbon-carbon double bond, are more preferable, and taking into consideration cost, hazardousness, and performances such as flexibility and high crosslinkability, 3-methacryloyloxypropyltrimethoxysilane is most preferable.

Tri- or tetravalent metal alkoxides preferable for the present invention include trimethoxyaluminum, triethoxyaluminum, tri-n-propoxyaluminum, tri-isopropoxyaluminum, tri-n-butoxyaluminum, tri-isobutoxyaluminum, tri-sec-butoxyaluminum, tri-tert-butoxyaluminum, trimethoxyboron, triethoxyboron, tri-n-propoxyboron, tri-isopropoxyboron, tri-n-butoxyboron, tri-isobutoxyboron, tri-sec-butoxyboron, tri-tert-butoxyboron, tetramethoxysilane, tetraethoxysilane, tetra-n-propoxysilane, tetra-isopropoxysilane, tetra-n-butoxysilane, tetra-isobutoxysilane, tetra-sec-butoxysilane, tetra-tert-butoxysilane, tetramethoxygermanium, tetra-ethoxygermanium, tetra-n-propoxygermanium, tetra-isopropoxygermanium, tetra-n-butoxygermanium, tetra-isobutoxygermanium, tetra-sec-butoxygermanium, tetra-tert-butoxygermanium, tetramethoxytitanium, tetra-ethoxytitanium, tetra-n-propoxytitanium, tetra-isopropoxytitanium, tetra-n-butoxytitanium, tetra-isobutoxytitanium, tetra-sec-butoxytitanium, tetra-tert-butoxytitanium, tetramethoxyzirconium, tetraethoxyzirconium, tetra-n-propoxyzirconium, tetra-isopropoxyzirconium, tetra-n-butoxyzirconium, tetra-isobutoxyzirconium, tetra-sec-butoxyzirconium and tetra-tert-butoxyzirconium. Taking into consideration that these metal alkoxides are preferably in a liquid form in the reaction temperature range to accomplish the rapid and uniform polymerization reaction, and high activities as a catalyst, their availability and the like, tetra-isopropoxytitanium is most preferable.

As described above, the polyorganosiloxane of the present invention can be polymerized and produced by suitably mixing and heating the silanol compound, the alkoxysilane compound and the metal alkoxide suitably used in the present invention. The heating temperature and the temperature-rising rate are important parameters for controlling the polymerization degree of the produced polyorganosiloxane. The temperature depends on the polymerization degree desired, but the raw material mixture described above is preferably heated and polymerized at about 70°C to 150°C.

If the addition amount of the metal alkoxide on polymerization falls below 2 mol% of the silanol compound suitably used in the present invention, even if the mixture is heated to or more than the preferable temperature range described above, the polymerization degree of the polyorganosiloxane cannot satisfactorily be raised. In such a case, addition of potassium hydroxide or sodium hydroxide in an appropriate amount as a catalyst makes up the shortfall of the metal alkoxide, and can reasonably control the polymerization degree of a produced polyorganosiloxane. In this case, potassium ions or sodium ions are left in polyorganosiloxane after finish of the reaction, but since these alkaline light metal ions can easily be removed using an ion exchange resin or the like to purify the polyorganosiloxane, the remaining of the ions raises particularly no practical problem, so the addition thereof is preferable.

However, if the silanol compound and the alkoxysilane compound of the present invention are tried to be polymerized only by the catalytic action of potassium hydroxide or sodium hydroxide without adding the metal alkoxide preferable in the present invention, polymer components having a high crystallinity are inevitably partially produced regardless of polymerization conditions, and these crystallize and deposit, making white turbidity and precipitation, and making the system inhomogeneous, which is unpreferable. The addition of the metal alkoxide of the present invention on polymerization is important also in view of avoiding the "crystallization", and the addition amount on polymerization is at least 0.1 mol% or more and more preferably 0.5 mol% or more, to the silanol compound preferably used in the present invention.

The upper limit of the addition amount of the metal alkoxide on polymerization depends on the performance of a polyorganosiloxane desired. To achieve the excellent UV-i line characteristics as described in the object of the present invention, the above-mentioned alkoxysilane compound having a photopolymerizable carbon-carbon double bond is essential, and the upper limit of the addition amount of the metal alkoxide on polymerization is at most 40 mol% or less and more preferably 30 mol% or less, to the silanol compound suitably used in the present invention, based on the calculation of the required minimum amount.

The polyorganosiloxane of the present invention has at least one structure selected from chemical structures of the following repeating units (5),

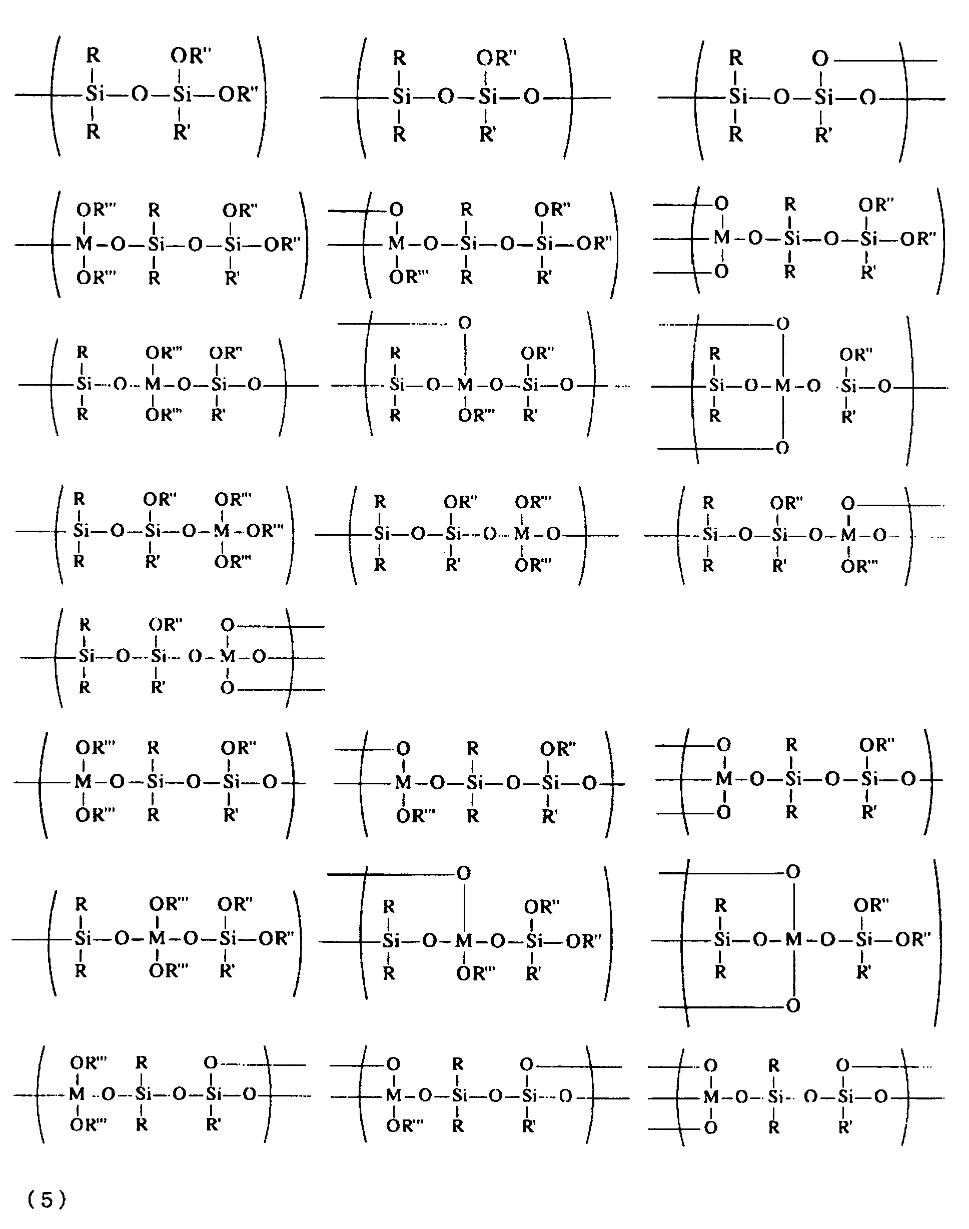

where R is a group having 6 to 20 carbon atoms containing at least one aromatic group; R' is a group having 2 to 17 carbon atoms containing at least one group selected from the group consisting of epoxy groups and carbon-carbon double bond groups; R" is a methyl group or an ethyl group; M denotes any one of silicon, germanium, titanium and zirconium; R"' is an alkyl group having 1 to 4 carbon atoms; and R may be crosslinked or may not.
Here, among the chemical structures described above, all or a part of (6), (8) and (10), respectively, may be replaced by (7), (9) and (11). Here, M denotes any one of silicon, germanium, titanium and zirconium; R"' is an alkyl group having 1 to 4 carbon atoms; M' denotes boron or aluminum; and R"" denotes an alkyl group having 1 to 4 carbon atoms.

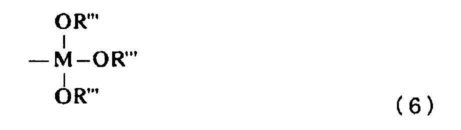

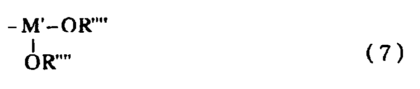

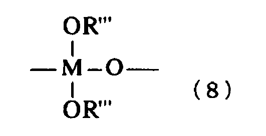

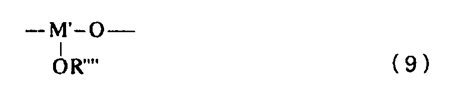

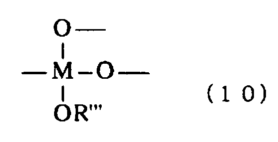

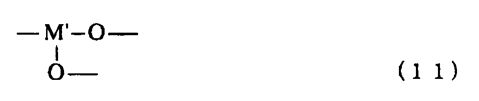

### (b) Photopolymerization initiators

In the composition of the present invention, addition of a photopolymerization initiator is important for imparting the photosensitivity. Preferable compounds include the following ones having an absorption at 365 nm.
(1) benzophenone derivatives such as benzophenone, 4,4'-bis(diethylamino)benzophenone, methyl o-benzoylbenzoate, 4-benzoyl-4'-methyldiphenyl ketone, dibenzyl ketone and fluorenone;
(2) acetophenone derivatives such as 2,2'-diethoxyacetophenone, 2-hydroxy-2-methylpropiophenone, 2,2-dimethoxy-1,2-diphenylethane-1-one, 1-hydroxycyclohexyl phenyl ketone, 2-methyl-1-[4-(methylthio)phenyl]-2-morpholinopropane-1-one, 2-hydroxy-1-{4-[4-(2-hydroxy-2-methylpropionyl)-benzyl]-phenyl}-2-methylpropane-1-one and methyl phenylglyoxylate;
(3) thioxanthone derivatives such as thioxanthone, 2-methylthioxanthone, 2-isopropylthioxanthone and diethylthioxanthone;
(4) benzil derivatives such as benzil, benzil dimethyl ketal and benzil-β-methoxyethyl acetal;
(5) benzoin derivatives such as benzoin, benzoin methyl ether and 2-hydroxy-2-methyl-1-phenylpropane-1-one;
(6) oxime compounds such as 1-phenyl-1,2-butanedione-2-(O-methoxycarbonyl)oxime, 1-phenyl-1,2-propanedione-2-(O-methoxycarbonyl)oxime, 1-phenyl-1,2-propanedione-2-(O-ethoxycarbonyl)oxime, 1-phenyl-1,2-propanedione-2-(O-benzoyl)oxime, 1,3-diphenylpropanetrione-2-(O-ethoxycarbonyl)oxime, 1-phenyl-3-ethoxypropanetrione-2-(O-benzoyl)oxime, 1,2-octanedion-1-[4-(phenylthio)-2-(O-benzoyl)]oxime and ethanone-1-[9-ethyl-6-(2-methylbenzoyl)-9H-carbazol-3-yl]-1-(O-acetyl)oxime;
(7) α-hydroxyketone compounds such as 2-hydroxy-2-methyl-1-phenylpropan-1-one, 1-[4-(2-hydroxyethoxy)phenyl]-2-hydroxy-2-methyl-1-propan-1-one and 2-hydroxy-1-{4-[4-(2-hydroxy-2-methylpropionyl)benzyl]phenyl}-2-methylpropane;
(8) α-aminoalkylphenone compounds such as 2-benzyl-2-dimethylamino-1-(4-morpholinophenyl)-butanone-1 (IRGACURE 369) and 2-dimethylamino-2-(4-methylbenzyl)-1-(4-morpholin-4-yl-phenyl)butane-1-one;
(9) phosphine oxide compounds such as bis(2,4,6-trimethylbenzoyl)-phenylphosphine oxide, bis(2,6-dimethoxybenzoyl)-2,4,4-trimethyl-pentylphosphine oxide and 2,4,6-trimethylbenzoyl-diphenyl-phosphine oxide;
(10) titanocene compounds such as bis(η⁵-2,4-cyclopentadien-1-yl)-bis(2,6-difluoro-3-(1H-pyrrol-1-yl)phenyl) titanium;
(11) benzoate compounds such as ethyl p-(N,N-dimethylaminobenzoate); and
(12) acridine derivatives such as 9-phenylacridine. These may be used singly or as a mixture of two or more.

Among the photopolymerization initiators described above, (8) α-aminoalkylphenone compounds are more preferable especially in view of photosensitivity. The addition amount thereof is preferably 0.1 to 20 parts by mass and more preferably 1 to 10 parts by mass, to the composition (a) of the present invention. An addition amount of 0.1 part by mass or more supplies radicals enough to fully advance photoradical polymerization on exposure, and sufficiently advances curing of the exposed portion, so a practical relief pattern can be obtained. In other hands, with an addition amount of 20 parts by mass or less, the exposure absorption nearly of the coated film surface does not become too large and the exposure light rays reaches nearly to the substrate surface, thereby making the photoradical polymerization uniform in the film thickness direction, so a practical relief pattern can be obtained.

### (c) Compounds other than the component (a), having two or more photopolymerizable unsaturated bond groups

In the composition of the present invention, for improving film-forming characteristics, photosensitive characteristics and mechanical characteristics after curing, addition of a compound, other than the component (a), having two or more photopolymerizable unsaturated bond groups is important. As such monomers, polyfunctional (meth)acrylate compounds, which can polymerize by the action of a photopolymerization initiator, are preferable, and include, for example, polyethylene glycol diacrylates [2 to 20 ethylene glycol units], polyethylene glycol dimethacrylates [2 to 20 ethylene glycol units], poly(1,2-propylene glycol) diacrylates [2 to 20 1,2-propylene glycol units], poly(1,2-propylene glycol) dimethacrylate [2 to 20 1,2-propylene glycol units], polytetramethylene glycol diacrylate [2-10 tetramethylene glycol units], polytetramethylene glycol dimethacrylates [2 to 10 tetramethylene glycol units], 1,4-cyclohexane diacrylate, 1,4-cyclohexane dimethacrylate, pentaerythritol triacrylate, pentaerythritol tetraacrylate, trimethylolpropane triacrylate, ethoxylated trimethylolpropane triacrylates [2 to 20 ethylene glycol units], trimethylolpropane trimethacrylate, tri-2-hydroxyethylisocyanurate triacrylate, tri-2-hydroxyethylisocyanurate trimethacrylate, glycerol diacrylate, glycerol dimethacrylate, ditrimethylolpropane triacrylate, ditrimethylolpropane tetraacrylate, dipentaerythritol pentaacrylate, dipentaerythritol hexaacrylate, methylene bisacrylamide, ethylene glycol diglycidyl ether-methacrylic acid adducts, glycerol diglycidyl ether-acrylic acid adducts, bisphenol A diglycidyl ether-acrylic acid adducts, bisphenol A diglycidyl ether-methacrylic acid adducts, ethoxylated bisphenol A diacrylates [2 to 30 ethylene glycol units], ethoxylated bisphenol A dimethacrylates [4 to 30 ethylene glycol units] and N,N'-bis(2-methacryloyloxyethyl)urea.

Among others, preferable are one or more compounds selected from the group consisting of ethoxylated bisphenol A dimethacrylates [4 to 30 ethylene glycol units] and polytetramethylene glycol dimethacrylates [2 to 10 tetramethylene glycol units].

As ethoxylated bisphenol A dimethacrylates [4 to 30 ethylene glycol units], the heat-resistant Blenmer PDBE-200, 250, 450 and 1300, made by NOF Corp., of the following formula are exemplified.

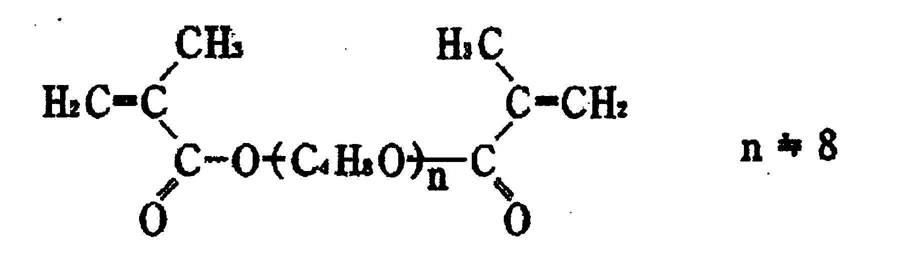

As polytetramethylene glycol dimethacrylates [2 to 10 tetramethylene glycol units], those having 5 to 10 tetramethylene glycol units are preferable, and the Blenmer PDT650, made by NOF Corp., of the following formula is exemplified.

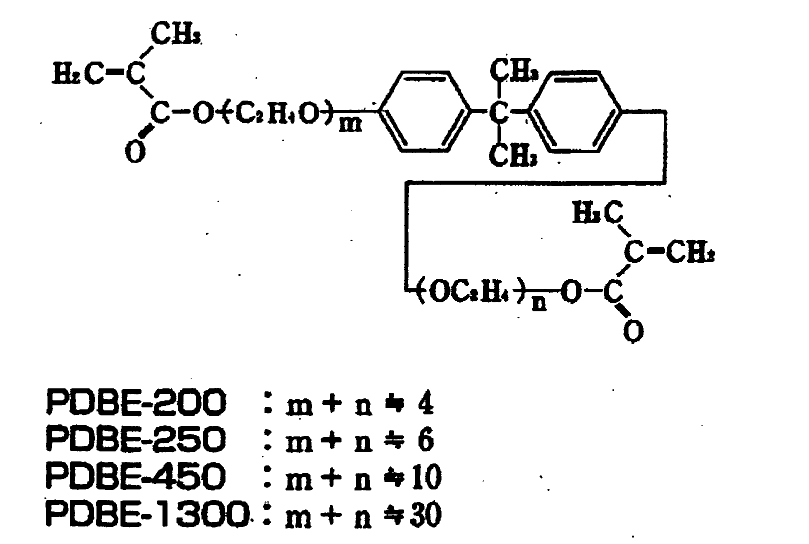

Among others, a dimethacrylate PDBE-450, in which 5 mols of ethylene oxide is added to each of both terminals of bisphenol A, or Blenmer PDT650 is most preferable.

These may be used singly or as a mixture of two or more, as required. The addition amount thereof is preferably 1 to 100 parts by mass and more preferably 5 to 50 parts by mass, to the component (a) of the present invention. With the addition amount of 100 parts by mass or less, the resin liquid is stable and has little variation in quality, which is preferable.

### (d) Silicone resins

In the composition of the present invention, for improving tackiness and fluidity of the coated film after soft-baking, a silicone resin may be added. The silicone resin mentioned here denotes a polymer described, for example, in "SILICONE HANDBOOK" (1990), published by The Nikkan Kogyo Shimbun, Ltd. (in Japanese), which has a three-dimensional network structure obtained by cohydrolyzing an organosilane compound having 2 to 4 hydrolyzable groups such as an alkoxysilyl group and a chlorosilyl group. Here, the component (a) in the present invention is considered as not corresponding to the silicone resin.

For the object of the present invention, among other silicone resins, a so-called straight silicone resin including a methyl, phenyl, phenyl methyl, phenyl ethyl, and phenyl propyl silicone resins is preferably added. Examples include methyl silicone resins such as KR220L, KR242A, KC89, KR400 and KR500 (made by Shin-Etsu Chemical Co., Ltd.), phenyl silicone resins such as 217 Flake (made by Dow Corning Toray Co., Ltd.), and SR-20 and SR-21 (made by Konishi Chemical Ind. Co., Ltd.), phenyl methyl silicone resins such as KR213 and KR9218 (made by Shin-Etsu Chemical Co., Ltd.), and 220 Flake, 223 Flake and 249 Flake (made by Dow Corning Toray Co., Ltd.), phenyl ethyl silicone resins such as SR-23 (made by Konishi Chemical Ind. Co., Ltd.), and phenyl propyl silicone resins such as Z-6018 (made by Dow Corning Toray Co., Ltd.).

For improving the tackiness and fluidity, a silicone resin which has a higher crosslinking density and is a solid in the ambient temperature range is preferably added, and in that sense, among the preferable examples described above, phenyl or phenyl propyl silicone resins are more preferably selected. Further, the tendency that the selection of a silicone resin having partially a silanol residue in its structure brings about the more enhanced improving effect on the tackiness and fluidity is revealed by studies by the present inventors, which is more preferable.

The addition amount of the silicone resin suitable for the present invention is preferably 50 to 200 parts by mass to the component (a) of the present invention. To obtain the improving effect on the tackiness and fluidity, a minimum of 50 parts by mass or more is necessary, and 200 parts by mass or less can maintain lithography characteristics such as i-line photosensitivity.

### (e) Organosilicon compounds

In the composition of the present invention, for improving the adhesiveness to every base material, an organosilicon compound can be added. An organosilicon compound represented by the general formula (2) shown below may be added,

R'Si(OR")₃ (2)

where R is a group having 6 to 20 carbon atoms containing at least one aromatic group; R' is an organic group having 2 to 17 carbon atoms containing at least one group selected from the group consisting of epoxy groups and carbon-carbon double bond groups; and R" is a methyl group or an ethyl group.
The organosilicon compounds specifically include the following: (hereinafter, the expression of alkoxy denotes methoxy or ethoxy group.) vinyltrialkoxysilane, 2-(3,4-epoxycyclohexyl)ethyltrialkoxysilane, 3-glycidoxypropyltrialkoxysilane, 3-glycidoxypropylmethyldialkoxysilane, p-styryltrialkoxysilane, 3-methacryloxypropyltrialkoxysilane, 3-methacryloxypropylmethyldialkoxysilane, 3-acryloxyprophyltrialkoxysilane, 3-acryloxyprophylmethyldialkoxysilane, N-(2-aminoethyl)-3-aminopropyltrialkoxysilane, N-(2-aminoethyl)-3-aminopropylmethyldialkoxysilane, 3-aminopropyltrialkoxysilane, 3-trialkoxysilyl-N-(1,3-dimethyl-butylidene)propylamine, N-phenyl-3-aminopropyltrialkoxysilane, 3-ureidopropyltrialkoxysilane, 3-ureidopropylmethyldialkoxysilane, 3-mercaptopropyltrialkoxysilane, 3-mercaptopropylmethyldialkoxysilane, bis(trialkoxysilylpropyl)tetrasulfide and 3-isocyanatopropyltrialkoxysilane.

Among others, preferable are one or more compounds selected from the group consisting of (CH₃O)₃-Si-(CH₂)₃-O-CO-C(CH₃)=CH₂, (CH₃O)₃-Si-(CH₂)₃-O-CO-CH=CH₂ and (CH₃O)₃-Si-(CH₂)₃-O-CH₂-C₂H₃O (the afore-mentioned C₂H₃O is an epoxy group). Further among them, (CH₃O)₃-Si-(CH₂)₃-O-CO-C(CH₃)=CH₂, namely, 3-methacryloxypropyltrimethoxysilane (hereinafter, referred to as MEMO in some cases) is preferable in view of the flexibility and the Sol-Gel crosslinkability. The addition amount when an adherence agent is added is preferably 0 to 20 parts by mass to the component (a) of the present invention in view of the stability of the photosensitive resin composition. It is more preferably 0.1 to 15 parts by mass and still more preferably 3 to 10 parts by mass.

### (f) Solvents

In the composition of the present invention, the viscosity can be adjusted by adding a solvent. Suitable solvents include N,N-dimethylformamide, N-methyl-2-pyrrolidone (hereinafter, also referred to as "NMP"), N-ethyl-2-pyrrolidone, tetrahydrofuran, N,N-dimethylacetamide (hereinafter, also referred to as "DMAc"), dimethylsulfoxide, hexamethylphosphoramide, pyridine, cyclopentanone, γ-butyrolactone (hereinafter, also referred to as "GBL"), α-acetyl-γ-butyrolactone, tetramethylurea, 1,3-dimethyl-2-imidazolinone, N-cyclohexyl-2-pyrrolidone, propylene glycol monomethyl ether, propylene glycol monomethyl ether acetate, methyl ethyl ketone, methyl isobutyl ketone, anisole, ethyl acetate, ethyl lactate and butyl lactate. They may be used singly or in combination of two or more. Above all, N-methyl-2-pyrrolidone, γ-butyrolactone and propylene glycol monomethyl ether acetate are most preferable. These solvents can be suitably added to the composition of the present invention according to the coating film thickness and the viscosity, but are preferably used in the range of 5 to 100 parts by mass to the component (a) of the present invention.

### (g) Other additives

In the composition of the present invention, as required, a sensitizer can be added to improve the photosensitivity. Such a sensitizer includes, for example, Michler's ketone, 4, 4'-bis(diethylamino)benzophenone, 2,5-bis(4'-diethylaminobenzylidene)cyclopentanone, 2,6-bis(4'-diethylaminobenzylidene)cyclohexanone, 2,6-bis(4'-dimethylaminobenzylidene)-4-methylcyclohexanone, 2,6-bis(4'-diethylaminobenzylidene)-4-methylcyclohexanone, 4,4'-bis(dimethylamino)chalcone, 4,4'-bis(diethylamino)chalcone, 2-(4'-dimethylaminocinnamylidene)indanone, 2-(4'-dimethylaminobenzylidene)indanone, 2-(p-4'-dimethylaminobiphenyl)benzothiazole, 1,3-bis(4-dimethylaminobenzylidene)acetone, 1,3-bis(4-diethylaminobenzylidene)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin, N-phenyl-N-ethylethanolamine, N-phenyldiethanolamine, N-p-tolyldiethanolamine, N-phenylethanolamine, N,N-bis(2-hydroxyethyl)aniline, 4-morpholinobenzophenone, isoamyl 4-dimethylaminobenzoate, isoamyl 4-diethylaminobenzoate, benztriazole, 2-mercaptobenzimidazole, 1-phenyl-5-mercapto-1,2,3,4-tetrazole, 1-cyclohexyl-5-mercapto-1,2,3,4-tetrazole, 1-(tert-butyl)-5-mercapto-1,2,3,4-tetrazole, 2-mercaptobenzothiazole, 2-(p-dimethylaminostyryl)benzoxazole, 2-(p-dimethylaminostyryl)benzthiazole, 2-(p-dimethylaminostyryl)naphtho(1,2-p)thiazole and 2-(p-dimethylaminobenzoyl)styrene. These may be used singly or as a mixture of two or more. The addition amount thereof must be balanced with other additive component amounts, but is preferably 0.1 to 10 parts by mass and more preferably 1 to 5 parts by mass, to the component (a) of the present invention.

In the composition of the present invention, as required, for improving the viscosity and the photosensitive stability during stockage, a polymerization inhibitor can be added. Such a polymerization inhibitor includes, for example, hydroquinone, N-nitrosodiphenylamine, p-tert-butylcatechol, phenothiazine, N-phenylnaphthylamine, ethylenediaminetetraacetic acid, 1,2-cyclohexanediaminetetraacetic acid, glycol ether diaminetetraacetic acid, 2,6-di-tert-butyl-p-methylphenol, 5-nitroso-8-hydroxyquinoline, 1-nitroso-2-naphthol, 2-nitroso-1-naphthol, 2-nitroso-5-(N-ethyl-N-sulfopropylamino)phenol, N-nitroso-N-phenylhydroxyamine ammonium salt, N-nitroso-N-phenylhydroxylamine ammonium salt, N-nitroso-N-(1-naphthyl)hydroxylamine ammonium salt and bis(4-hydroxy-3,5-di-tert-butyl)phenylmethane. The addition amount thereof is preferably 0 to 5 parts by mass and more preferably 0.01 to 1 part by mass, to the component (a) of the present invention.

In addition to the above, as required, various types of additives including an ultraviolet absorbent and a coating film smoothing agent can suitably be formulated in the composition of the present invention, as long as these additives do not inhibit various characteristics of the composition of the present invention.

### <Forming method of a cured relief pattern and a polyorganosiloxane film>

Then, a preferable example of methods of forming a cured relief pattern using the composition of the present invention will be described hereinafter.

First, the composition is coated on various desired types of bases such as a silicon wafer, a ceramic substrate, an aluminum substrate and others. As a coating apparatus or a coating method can be used a spin coater, a die coater, a spray coater, immersion, printing, a blade coater, roll coating and the like. A coated base is soft-baked at 80 to 200°C for 1 to 15 min, and thereafter irradiated with active light rays through a desired photomask using an exposing projector such as a contact aligner, a mirror projector and a stepper.

As active light rays can be used X-rays, electron beams, ultraviolet rays, visible light rays and the like, but in the present invention, rays of 200 to 500 nm in wavelength are preferably used. The light source wavelength is most preferably the UV-i line (365 nm) in view of the resolution of patterns and the handleability, and an exposing projector is most preferably a stepper.

Thereafter, for improving the photosensitivity, as required, post-exposure baking (PEB) or pre-development baking may be performed in a combination of an arbitrary temperature and time (preferably, at a temperature of 40°C to 200°C for a time of 10 sec to 360 sec).

Then, development is performed by selecting a method such as an immersion method, a paddle method or a rotational spray method. As a developing solution, a good solvent for the composition of the present invention singly, or a suitable mixture of a good solvent and a poor solvent can be used. As a good solvent used are N-methyl-2-pyrrolidone, N-acetyl-2-pyrrolidone, N,N-dimethylacetamide, N,N-dimethylformamide, dimethylsulfoxide, γ-butyrolactone, α-acetyl-γ-butyrolactone, cyclopentanone, cyclohexanone, propylene glycol monomethyl ether, propylene glycol monomethyl ether acetate, methyl ethyl ketone, methyl isobutyl ketone and the like; as a poor solvent used are methanol, ethanol, isopropanol, water and the like.

After finish of the development, cleaning is performed with a rinsing solution to remove the developing solution to obtain a coated film with a relief pattern. As a rinsing solution, distilled water, methanol, ethanol, isopropanol, propylene glycol monomethyl ether and the like may be used singly or as a suitable mixture thereof, or in a stepwise combination.

The relief pattern thus obtained is converted to a cured relief pattern at a far lower temperature of 150 to 250°C than conventional cases of polyimide precursor compositions. The heat curing can be performed using a hot plate, an inert oven, a temperature-rising type oven whose temperature program can be set, or the like. The atmospheric gas in heat curing to be used may be air, or as required, an inert gas such as nitrogen or argon.

By using the cured relief pattern described above as one selected from the group consisting of surface protecting films, interlayer insulating films and α-ray shielding films of semiconductor devices formed on bases such as silicon wafers, and supports (partitions) between microstructures such as microlens arrays and their packages, and by applying well-known manufacturing methods of semiconductor devices for other processes, various types of semiconductor devices including optical elements such as CMOS image sensors can be manufactured. Further, electronic components and semiconductor devices having a coated film composed of a resin obtained by curing the composition described above can be provided.

### <A method of manufacturing a microplastic lens and an optical element for liquid crystal sheet polarizers utilizing a mold for moldings>

A method of forming the photosensitive resin composition of the present invention on a glass substrate with good adhesiveness using a metal mold will be described hereinafter. The microplastic lens and the optical element for liquid crystal sheet polarizers differ only in the size and type of the molds, and the manufacturing methods are the same.

1) A step of coating on a glass substrate and heating: the photosensitive resin composition of the present invention is diluted with a solvent such as NMP, and coated on a substrate by a method of coating using, for example, a spin coater, a bar coater, a blade coater, a curtain coater or a screen printing machine, or spray-coating using a spray coater or the like to form a thin film of the photosensitive resin composition. The thickness of the photosensitive resin composition is preferably 0.1 to 10 µm, more preferably 0.5 to 5 µm and still more preferably 1 to 3 µm. Heating is performed with the glass substrate surface on which the photosensitive resin composition thin film has been formed being directed upward. The apparatus to be used is any well-known apparatus capable of heating, such as an oven, a far infrared oven or a hot plate. Above all, a hot plate is preferable in view of raising the adhesiveness of the glass substrate and the photosensitive resin composition. The heating is performed in the range of 50°C to 150°C, preferably in the range of 100°C to 140°C, for 1 min to 30 min, preferably for 5 min to 10 min.

2) A step of pressing a mold for moldings: separately, the photosensitive resin composition of the present invention is filled in a mold for a microplastic lens or a mold for an optical element for liquid crystal sheet polarizers; and the mold for moldings is pressed on and adhered to the glass substrate surface on which the thin film has been formed in the step 1). The method of filling in the mold for moldings involves dropping with a dropper, a dispenser or the like. The material of the mold for moldings to be used is rubber, glass, plastics, metals or the like. In the case of a metal mold for moldings, a nickel-made mold is preferable.

3) A step of exposure: in the state that the photosensitive resin is interposed between the glass substrate and the mold for moldings, ultraviolet rays are irradiated from the glass substrate side. The exposing light wave length is preferably the i-line in view of the resolution of patterns and handleability as a photocurable resin, and the apparatus is preferably a projection aligner of a proximity exposure type.

4) A step of separating the mold: after the ultraviolet curing, the mold for moldings is separated off the glass substrate.

5) A step of heating: by heating at a temperature of 150°C to 250°C for 0.5 hour to 2 hours, remaining methacryl groups are bonded to obtain a microplastic lens and an optical element for liquid crystal sheet polarizers excellent in heat resistance. The heating can be performed using a hot plate, an inert oven or a temperature-rising type oven whose temperature program can be set. The atmospheric gas in heating conversion to be used may be air or an inert gas such as nitrogen or argon.

### <A manufacturing method of a microplastic lens using a mask>

A method of forming a microplastic lens by coating the transparent photosensitive resin composition having a siloxane structure of the present invention on a glass substrate or a silicon substrate (hereinafter, referred to as substrate) with a good adhesiveness by using a mask will be described hereinafter.

1) A step of coating on a substrate and heating: the photosensitive resin composition of the present invention is diluted with a solvent such as NMP, and coated on the substrate by a method of coating using, for example, a spin coater, a bar coater, a blade coater, a curtain coater or a screen printing machine, or spray-coating using a spray coater or the like to form a thin film of the photosensitive resin composition. Thickness of the photosensitive resin composition is preferably 1 to 30 µm, more preferably 2 to 10 µm and still more preferably 3 to 6 µm.

Heating is performed with the glass substrate surface on which the thin film of the photosensitive resin composition has been formed being directed upward. The apparatus to be used is any well-known apparatus capable of heating, such as an oven, a far infrared oven or a hot plate. Among others, a hot plate is preferable in view of raising the adhesiveness of the photosensitive resin composition to the substrate. The heating is performed in the range of 50°C to 150°C, preferably in the range of 100°C to 140°C, and for 1 min to 30 min, preferably for 5 min to 10 min.

2) A step of multiple exposure: by using a plurality of masks composed of circular patterns of a microplastic lens, the resultant composition-adhered substrate is exposed to ultraviolet rays, in a constant exposure level of a remaining-film saturated minimum exposure level after development etching divided by the number of the masks, through every mask sequentially starting from a mask of the smallest circular diameter. If alignment marks of the plurality of masks are aligned, the lens patterns make concentric patterns having different diameters. For example, for exposing and forming a negative-type transparent photosensitive resin into a microplastic lens shape using three masks, the exposure is three times performed sequentially starting from the mask having the smallest pattern in the same exposure level of a remaining-film saturated minimum exposure level after development divided by the number of the masks (for example, 90 mJ/cm²÷3=30 mJ/cm²) using the alignment marks.

3) A step of development: development can be performed by selecting any method from conventional known photoresist developing methods, for example, a rotary spray process, a paddle process or an immersion process involving the ultrasonic treatment.

A developing solution to be used is preferably a combination of a good solvent and a poor solvent to the above-mentioned polymer precursor. As good solvents to be used are N-methylpyrrolidone, N-acetyl-2-pyrrolidone, N,N'-dimethylacetamide, cyclopentanone, cyclohexanone, γ-butyrolactone, α-acetyl-γ-butyrolactone, methyl isobutyl ketone and the like; as poor solvents to be used are toluene, xylene, methanol, ethanol, isopropanol, water and the like. The proportion of a poor solvent to a good solvent is adjusted by the solubility of a photosensitive resin having a siloxane structure. The solvents may be used in a combination thereof.

4) A final step of heating: by heating at a temperature of 150°C to 250°C for 0.5 hour to 2 hours, remaining methacryl groups are bonded to obtain a microplastic lens and an optical element for liquid crystal sheet polarizers excellent in heat resistance. The heating can be performed using a hot plate, an inert oven or a temperature-rising type oven whose temperature program can be set. As the atmospheric gas in heating conversion may be used air or an inert gas such as nitrogen or argon.

Here, the above-mentioned remaining-film saturated minimum exposure level after development etching means the following.

Negative-type resists exhibit different remaining-film ratios after development depending on the exposure level.

The determining method of a remaining-film saturated minimum exposure level after development etching is performed using Fig. 1 shown later.

When the exposure set values in an exposing apparatus are shown on the abscissa and the remaining-film thicknesses after the development at that time are shown on the ordinate, the remaining-film thickness is found to saturate nearly at 2.5 µm.

The minimum exposure level at this time is found to be 100 mJ/cm² from the graph in Fig. 1.

Such a minimum exposure level (for example, 100 mJ/cm²) is referred to as the remaining-film saturated minimum exposure level after development etching.

### EXAMPLES

Then, the present invention will be described by way of Examples and Comparative Examples.

### [Synthesis Example 1]

### (Synthesis of a polyorganosiloxane P-1)

In a round-bottom flask of 2 L in volume installed with a water-cooled condenser and stirring blades with a vacuum seal, 540.78 g (2.5 mol) of diphenylsilanediol (hereinafter, DPD), 577.41 g (2.325 mol) of 3-methacryloyloxypropyltrimethoxysilane (hereinafter, MEMO) and 24.87 g (0.0875 mol) of tetra-isopropoxytitanium (hereinafter, TIP) were charged; and stirring was started. The charged flask was immersed in an oil bath; the heating temperature was set at 120°C; and heating was started from room temperature. The solution was reacted till the reaction solution temperature became constant while methanol generated in the progress of the polymerization reaction was refluxed by a water-cooled condenser; and thereafter, stirring under heating was continued further for 30 min.

Thereafter, the flask was installed with a hose connected to a cold trap and a vacuum pump; and by strongly stirring the solution while heating at 80°C using an oil bath and gradually raising the vacuum degree in such an extent that methanol does not bump, methanol was distilled out to obtain a polyorganosiloxane P-1 (the viscosity at 23°C was 100 poises).

### [Synthesis Example 2]

### (Synthesis of a polyorganosiloxane P-2)

In a round-bottom flask of 2 L in volume installed with a water-cooled condenser and stirring blades with a vacuum-seal, 432.62 g (2.0 mol) of DPD, 495.71 g (1.996 mol) of MEMO, 0.568 g (0.002 mol) of TIP and 0.16 g (0.004 mol) of sodium hydroxide were charged; and stirring was started. The charged flask was immersed in an oil bath; the heating temperature was set at 80°C; and heating was started from room temperature. The solution was reacted till the reaction solution temperature became constant while methanol generated in the progress of the polymerization reaction was refluxed by a water-cooled condenser; and thereafter, stirring under heating was continued further for 30 min.

Thereafter, the reaction solution was cooled to room temperature, and passed through a glass column filled with an ion exchange resin (made by Organo Corp., Amberlist 15, the resin of 40 g in dry weight swollen and washed with methanol) to remove sodium ions.

The solution was moved to a round-bottom flask installed with stirring blades with a vacuum seal and a hose connected to a cold trap and a vacuum pump; the flask was immersed in an oil bath heated at 80°C; while the solution was strongly stirred, methanol was removed by gradually raising the vacuum degree in such an extent that methanol does not bump to obtain a polyorganosiloxane P-2 (the viscosity at 23°C was 50 poises). As a result of ICP-MS ion analysis, the sodium ion concentration in P-2 was less than 1 ppm.

### [Synthesis Example 3]

### (Synthesis of a polyorganosiloxane P-3)

A polyorganosiloxane P-3 (the viscosity at 23°C was 78 poises) was obtained as in Synthesis Example 1, except for using tetra-isopropoxyzirconium in place of TIP in Synthesis Example 1.

### [Synthesis Example 4]

### (Synthesis of a polyorganosiloxane P-4)

A polyorganosiloxane P-4 (the viscosity at 23°C was 122 poises) was obtained as in Synthesis Example 1, except for that the charging amount of MEMO was 565.0 g (2.275 mol) and 30.63 g (0.15 mol) of tri-isopropoxyaluminum was charged in place of TIP in Synthesis Example 1.

### [Synthesis Example 5]

### (Synthesis of a polyorganosiloxane P-5)

A polyorganosiloxane P-5 (the viscosity at 23°C right after methanol was distilled out was 52 poises) was obtained by the same operation as in Synthesis Example 2, except for that the charging amount of MEMO was 496.7 g (2.0 mol), TIP was not added, and only sodium hydroxide was used as the catalyst. The obtained P-5 was in a slightly cloudy state already before the ion exchange treatment, but after methanol was distilled out, the white turbidity further progressed and, after P-5 was allowed to stand at room temperature for one day, it involved white microparticulate crystalline precipitations. As in Synthesis 2, based on ICP-MS ion analysis, the sodium ion concentration in P-5 was less than 1 ppm.

### [Synthesis Example 6]

### (Synthesis of a polyamide P-6)

In a separable flask of 5L in volume, 310.22 g (1.00 mol) of diphenyl ether-3,3',4,4'-tetracarboxylic dianhydride, 270.69 g (2.08 mol) of 2-hydroxyethyl methacrylate, 158.2 g (2.00 mol) of pyridine and 1,000g of γ-butyrolactone were charged and mixed, and stirred at ambient temperature for 16 hours. Thereto, a solution in which 400.28 g (1.94 mol) of dicyclohexylcarbodiimide was dissolved in and diluted with 400 g of γ-butyrolactone was dropwise charged over about 30 min under ice cooling, and successively, a solution in which 185.97 g (0.93 mol) of 4,4'-diaminodiphenyl ether was dispersed in 650g of γ-butyrolactone was added spending about 60 min. The resultant solution was stirred for 30 min still under ice cooling; thereafter, 50 g of ethanol was added thereto; the ice cooling bath was removed; and the solution was stirred for 1 hour. After a solid content (dicyclohexylurea) having deposited in the above process was pressed and filtered, the reaction solution was dropwise charged in 40 L of ethanol; and a polymer precipitated at this time was separated and washed and dried in vacuum at 50°C for 24 hours to obtain a polyamide P-6. The GPC weight-average molecular weight (in tetrahydrofuran) as polystyrene was 25,500.

### [Example 1]

### (Preparation of a polyorganosiloxane composition C-1)

100 parts by mass of the polyorganosiloxane P-1 obtained in Synthesis Example 1, 4 parts by mass of 2-benzyl-2-dimethylamino-1-(4-morpholinophenyl)-butanone-1, 1 part by mass of 4,4'-bis(diethylamino)benzophenone, 10 parts by mass of a polytetramethylene glycol dimethacrylate (8 tetramethylene glycol units; PDT-650, made by NOF Corp.), and 5 parts by mass of 3-methacryloxypropyltrimethoxysilane were weighed and mixed, and filtered with a filter made of Teflon® of 0.2 µm in pore size to obtain a vanish-like polyorganosiloxane composition C-1.

### [Example 2]

### (Preparation of a polyorganosiloxane composition C-2)

100 parts by mass of the polyorganosiloxane P-1 obtained in Synthesis Example 1, 4 parts by mass of 2-benzyl-2-dimethylamino-1-(4-morpholinophenyl)-butanone-1, 1 part by mass of 4,4'-bis(diethylamino)benzophenone, 30 parts by mass of a polytetramethylene glycol dimethacrylate (8 tetramethylene glycol units; PDT-650, made by NOF Corp.), 10 parts by mass of 3-methacryloxypropyltrimethoxysilane, 150 parts by mass of a silicone resin (217Flake, made by Dow Corning Toray Co., Ltd.), and 40 parts by mass of N-methyl-2-pyrrolidone were weighed and mixed, and filtered with a filter made of Teflon® of 0.2 µm in pore size to obtain a vanish-like polyorganosiloxane composition C-2.

### [Example 3]

### (Preparation of a polyorganosiloxane composition C-3)

A polyorganosiloxane C-3 was obtained as in Example 2, except for using the P-2 of Synthesis Example 2 as a polyorganosiloxane.

### [Example 4]

### (Preparation of a polyorganosiloxane composition C-4)

A polyorganosiloxane C-4 was obtained as in Example 2, except for using the P-3 of Synthesis Example 3 as a polyorganosiloxane.

### [Example 5]

### (Preparation of a polyorganosiloxane composition C-5)

A polyorganosiloxane C-5 was obtained as in Example 2, except for using the P-4 of Synthesis Example 4 as a polyorganosiloxane.

### [Comparative Example 1]

### (Preparation of a polyorganosiloxane composition C-6)

Raw materials were weighed and mixed as in Example 2, except for using the P-5 of Synthesis Example 5 as a polyorganosiloxane. Thereafter, the mixture was tried to be filtered with a filter made of Teflon® of 0.2 µm in pore size, but clogging occurred on the way conceivably due to white turbidity components originated from the polyorganosiloxane P-5, disabling the filtration, and the operations thereafter was given up.

### [Comparative Example 2]

### (Preparation of a polyorganosiloxane composition C-7)

A vanish-like polyorganosiloxane composition C-7 was obtained as in Example 1, except for excluding the polytetramethylene glycol dimethacrylate (8 tetramethylene glycol units, PDT-650, made by NOF Corp.) from the composition of Example 1.

### [Comparative Example 3]

### (Preparation of a photosensitive polyamide composition C-8)

100 parts by mass of the photosensitive polyamide P-6 obtained in Synthesis Example 6, 4 parts by mass of 1,3-diphenylpropanetrione-2-(O-ethoxycarbonyl)oxime, 1 part by mass of 1-phenyl-5-mercapto-1,2,3,4-tetrazole, 3 parts by mass of N,N-bis(2-hydroxyethyl)aniline, 0.05 part by mass of N-nitrosodiphenylamine, 4 parts by mass of tetraethylene glycol dimethacrylate, and 240 parts by mass of N-methyl-2-pyrrolidone were mixed and dissolved, and filtered with a filter made of Teflon® of 0.2 µm in pore size to obtain a vanish-like photosensitive polyamide composition C-8.

### (Evaluation of tackiness)

The vanish-like photosensitive compositions obtained in Examples of the present invention and Comparative Examples were each coated on a 5-inch silicon wafer using a spin coater (made by Tokyo Electron Ltd., model name: Clean Track Mark 7), and soft-baked at 125°C for 12 min to obtain a coated film of 44 µm in initial film thickness.

The coated film was touched with a finger tip to evaluate the degree of tackiness (stickiness). The evaluation criterion was defined in such three stages that the case where the coated film had a stickiness in the same level as that before the soft-baking was laid down as "×"; the case where it had an adhesiveness when touched and clearly left a touching trace was laid down as "Δ"; and the case where it left a minor touching trace or no touching trace was laid down as "○". The results are shown in Table 1.

### (Evaluation of lithography)

Coated films obtained similarly to the above were each exposed using an i-line stepper exposing machine (made by Nikon Corp., model name: NSR2005i8A) and through a photomask for evaluation in which a mock lattice pattern of a spacer for lens array protection of a CMOS image sensor was designed, by varying the exposure level stepwise by 100 mJ/cm² in the lateral direction in the range of 100 to 900 mJ/cm² and varying the focus stepwise by 2 microns in the longitudinal direction in the range of 16 µm to 32 µm. At 30 min after the exposure, the coated films obtained from the compositions of Examples 1 to 5 and Comparative Examples 2 and 3 were each subjected to a rotary spray development using propylene glycol monomethyl ether acetate as a developing solution and for a time till the unexposed portion was completely dissolved and eliminated multiplied by 1.4, and successively subjected to a rotary spray rinsing using isopropanol for 10 sec to obtain a lattice relief pattern. With respect to the coated film obtained from the composition of Comparative Example 3, cyclopentanone was used as the developing solution, and propylene glycol monomethyl ether acetate was used as the rinsing solution; and the development and the rinsing treatment similar to the above were performed to obtain a lattice relief pattern.

The obtained relief patterns were each observed visually with an optical microscope, and evaluated for the presence/absence of residues of the developed portion (○: no residue, Δ: local slight residue, ×: much residue), the presence/absence of swelling of patterns (○: no swelling, and sharp pattern, Δ: local slight swelling, ×: clear swelling), and the presence/absence of floating and exfoliation from the substrate (○: no floating and exfoliation, Δ: local slight floating and exfoliation, ×: overall or clear floating and exfoliation). The results are shown in Table 1.

### (Evaluation of a low-temperature curing characteristic: the tensile elongation of cured films)

Each composition of Examples and Comparative Examples described above were coated and soft-baked on a base in which aluminum was vacuum deposited on a 5-inch silicon wafer similarly to the lithography evaluation described above, and thereafter, the baked composition was heat cured in a nitrogen atmosphere at 180°C for 2 hours using a vertical curing oven (made by Koyo Thermo System Co., Ltd., model name: VF-2000B) to fabricate a resin film of 15 µm in film thickness after curing. The resin film was cut into 3.0-mm width using a dicing saw (made by Disco Corp., model name: DAD-2H/6T), immersed in a 10% hydrochloric acid aqueous solution, and peeled off the silicon wafer to make strip film samples.

The film samples were allowed in an atmosphere of 23°C and 55%RH for 24 hours, and then subjected to a tensile test by Tensilon according to ASTMD-882-88 to evaluate the elongation. The results are shown in Table 2.

### (Evaluation of degassing properties: the 5% weight reduction temperature and the 150°C-soaked weight reduction ratio)

Using the strip film samples having been adjusted for the elongation evaluation described above, degassing properties were evaluated by two methods. The results for both are shown in Table 2.

### 1) 5% weight reduction temperature

The temperature indicating the 5% weight reduction was measured using a thermogravimetric analyzer (made by Shimadzu Corp., model name: TGA-50). The measuring conditions were the measuring temperature range of 25°C to 450°C, a temperature rising rate of 10°C/min, and a nitrogen atmosphere.

### 2) 150°C-soaked weight reduction ratio

Similarly using TGA-50, the weight reduction ratio (unit: %) in the 150°C-soaking treatment was measured. The measuring conditions were a temperature rising rate up to 150°C of 10°C/min, a 150°C-soaking treatment temperature of 2 hours, and a nitrogen atmosphere.

### (Evaluation of the volume shrinkage on heat curing)

The thicknesses of the coated film before and after the heat curing treatment at 180°C for 2 hours using the vertical curing oven, which treatment was performed when the samples for the tensile elongation evaluation described above were fabricated, were measured using a stylus profiler (made by KLA-Tencor Corp., model name: P-15) to calculate its changing ratio (remaining-film ratio, unit: %) as an indication of the volume shrinkage. The results are shown in table 2.

### (Evaluation of the transparency)

The compositions of Examples and Comparative Examples described above were each uniformly coated on a quartz plate of 1 mm in thickness and 40 mm square by a simple spin coater, soft-baked at 125°C for 6 min, and overall exposed using a broad band exposing machine (made by Canon Corp., model name: PLA-501). The exposed composition was subjected to a heat curing process at 180°C for 2 hours by the method similar to the sample fabrication for the tensile elongation evaluation to obtain a heat cured film of about 10 µm in film thickness. The light transmissivity per 10 µm of the heat cured film thickness at a wavelength of 600 nm of the cured film was measured and calculated as an indication of the transparency using an ultraviolet-visible spectrophotometer (made by Shimadzu Corp., UV1600PC). The results are shown in Table 2.

**[Table 1]**

| | Tackiness | Lithography characteristics | | |
|---|---|---|---|---|
| | | Residue on developed portion | Swelling of pattern | Floating and exfoliation of pattern |
| Example 1 | × | ○ | ○ | ○ |
| Example 2 | ○ | ○ | ○ | ○ |
| Example 3 | ○ | ○ | ○ | ○ |
| Example 4 | ○ | ○ | ○ | ○ |
| Example 5 | ○ | ○ | ○ | ○ |
| Comparative Example 1 | - | - | - | - |
| Comparative Example 2 | × | △ | △ | × |
| Comparative Example 3 | ○ | ○ | ○ | ○ |

**[Table 2]**

| | Low-temperature curability: Elongation (%) | Degassing property | | Volume shrinkage: Remaining- film ratio after curing (%) | Transparency: Light transmissivity per 10 µm of film thickness (%) |
|---|---|---|---|---|---|
| | | 5% weight reduction temperature (°C) | 150°C-soaked weight reduction ratio (%) | | |
| Example 1 | 15 | 356 | 0.3 | 95 | 100 |
| Example 2 | 24 | 349 | 0.5 | 98 | 100 |
| Example 3 | 21 | 351 | 0.4 | 99 | 100 |
| Example 4 | 19 | 345 | 0.3 | 98 | 99.9 |
| Example 5 | 20 | 349 | 0.2 | 98 | 100 |
| Comparative Example 1 | - | - | - | - | - |
| Comparative Example 2 | 3 | 350 | 0.3 | 94 | 99.9 |
| Comparative Example 3 | unmeasureable | 249 | 5.2 | 72 | 81.2 |

The Examples of the present invention exhibit excellent lithography characteristics and low-temperature characteristics, has a very small volume shrinkage in heat curing, and achieve excellent transparency and a low degassing property in a high level also after heat curing. Further comparing the tackinesses of the coated films after soft-baking of Example 1 and Examples 2 to 5, it is clarified that the coated film after soft-baking can be made tack free, as desired.

Comparative Example 1 is a case where only sodium hydroxide was used as a catalyst on polymerization of a polyorganosiloxane, in which case the system was whitely clouded on polymerization, thereby resulting in incapable filtration of the vanish-like composition, which is of no practical use.

Comparative Example 2 is a case where a compound (c), other than the component (a), being an essential component of the present invention having two or more photopolymerizable unsaturated bond groups was not used, and is inferior in the lithography characteristics as well as the low-temperature curability to the present invention.

Comparative Example 3 is an example of a common photosensitive polyamide (polyimide precursor) conventionally used, and is far inferior in any of the low-temperature curability, degassing property, volume shrinkage and transparency to the present invention, whose superiority is obvious. The organosiloxane composition of the present invention is preferable for insulating materials of electronic components and formation of surface protecting films, interlayer insulating films, alpha-ray shielding films and the like in semiconductor devices, and semiconductor devices and the like mounting image sensors, micromachines or microactuators, and as a resin composition used for their formation.

### [Example 6]

1) To ORMOCER® ONE (for synthesis of ORMOCER ONE, reaction temperature: 80°C, reaction time: 15 min, catalyst: 0.002 mol of Ba(OH)₂H₂O) from Fraunhofer ISC in Germany, a photosensitive resin obtained by reacting DPD and MEMO in 1:1 in molar ratio, 0.1% by mass of a photopolymerization initiator IRGACURE 369 (made by Ciba-Geigy Corp.) and 20% by mass of a polyethylene oxide bisphenol A dimethacrylate (made by NOF Corp., trade name: heat resistive Blenmer PDBE 450) were added and mixed, and filtered with a filter of 0.2 µm to make a photosensitive resin composition. The final viscosity was 15 poises.

2) The composition was spin coated in a spin coating condition of 1,000 rpm for 30 sec on an alkali-free glass (thickness: 0.7 mm, longitudinal/lateral sizes: 10 cm × 10 cm, made by Corning Inc.) to obtain a spin-coated film of 30 µm in thickness. The spin-coated film was prebaked at 120°C for 5 min to remove residual volatile components, when no shrinkage as well as no decrease in flatness of the film were observed.

3) The preferable composition was exposed from the front using no mask to UV (wavelength: 365 nm) in a light amount of 400 mJ/cm² to crosslink the composition.

4) Finally, the composition was cured in nitrogen at 250°C for 2 hours to complete curing. At this time, since the SiO₂ nanosize particles aggregate already before the heat treatment, the organic inorganic photosensitive resin having a siloxane structure did not cause a film shrinkage and held a very flat film structure though having been subjected to the heat curing treatment.

### [Example 7]

1) To ORMOCER® ONE, the same as in Example 6, 0.1% by mass of a photopolymerization initiator IRGACURE 369 (made by Ciba-Geigy Corp.), 20% by mass of a polyethylene oxide bisphenol A dimethacrylate (made by NOF Corp., trade name: heat resistive Blenmer PDBE 450) and 3% by mass of MEMO were added and mixed, and filtered with a filter of 0.2 µm to make a photosensitive resin composition. The final viscosity was 15 poises.

2) The spin-coated film was prebaked at 120°C for 5 min to remove residual volatile components, when no shrinkage as well as no decrease in flatness of the film were observed.

3) The preferable composition was exposed from the front using no mask to UV (wavelength: 365 nm) in a light amount of 400 mJ/cm² to crosslink the composition.

4) Finally, the composition was cured in nitrogen at 250°C for 2 hours to complete curing. At this time, since the SiO₂ nanosize particles aggregate already before the heat treatment, the organic inorganic photosensitive resin having a siloxane structure did not cause a film shrinkage and held a very flat film structure though having been subjected to the heat curing treatment.

### [Comparative Example 4]

1) A photosensitive resin composition was obtained as in Example 6, except for that the polyethylene oxide bisphenol A dimethacrylate (made by NOF Corp., trade name: heat resistive Blenmer PDBE 450) was not added and mixed. The final viscosity was 15 poise.

2) The spin-coated film was prebaked at 120°C for 5 min to remove residual volatile components, when no shrinkage as well as no decrease in flatness of the film were observed.

3) The preferable composition was exposed from the front using no mask to UV (wavelength: 365 nm) in a light amount of 400 mJ/cm² to crosslink the composition.

4) Finally, the composition was cured in nitrogen at 250°C for 2 hours to complete curing. At this time, since the SiO₂ nanosize particles aggregate already before the heat treatment, the organic inorganic photosensitive resin having a siloxane structure did not cause a film shrinkage and held a very flat film structure though having been subjected to the heat curing treatment.

The photosensitive resin compositions obtained in Examples 6 and 7 and Comparative Example 4 were evaluated for the following. The evaluation results are collectively shown in Table 3.

### <The evaluation method of adhesive force>

A film was formed on a Si wafer with a Cu sputter film according to 1) to 4) of each of Examples 6 and 7 and Comparative Example 4. Then, according to the cross-cut tape peeling test (JIS K5400), the film was scored with a cutter knife using a cross-cut guide No. 1 so as to form 100 1×1 mm squares; a cellophane tape was pasted from above on the squares, and peeled; and the number of the squares not adhered to the cellophane tape and remaining on the substrate was counted and the adhesiveness was thus evaluated.

With respect to the adhesive force in this case, the case where 100 squares remain represents 60 MPa; the case where about 50 squares remain represents 30 MPa; and the case where 10 or less squares remain represents 10 MPa.

### <The evaluation method of breaking point elongation>

A film was formed on a Si wafer with an Al sputter film according to 1) to 4) of each of Examples 6 and 7 and Comparative Example 4. The film was cut into 3.0 mm width using a dicing saw (made by Disco corp., model name: DAD-2H/6T), immersed in a 10 mass% hydrochloric acid solution to peel the film off the silicon wafer to make strip film samples. The strip film sample was set on a measuring apparatus (made by Orientec Co., Ltd., model name: TENSILON UTM-II-20) and measured with a between-chuck distance of 50 mm and a tensile rate of 40 mm/min according to the tensile breaking strain test (JIS K7161).

### <Moisture resistance test>

The resins formed as a film on a glass substrate of Examples 6 and 7 and Comparative Example 4 were each subjected to a stress test by a thermohygrostat (made by Yamato Scientific Co., Ltd., model name: IW221) under the conditions of a temperature of 60°C and a humidity of 90% till 1,000 hours; and changes in the light transmissivity (a light transmission measuring instrument: made by Shimadzu Corp., UV-3101PC, 400 nm in wavelength) before and after the stress, exfoliations and cracks were evaluated.

**[Table 3]**

| | Example 6 | Example 7 | Comparative Example 4 |
|---|---|---|---|
| Breaking point elongation | 14% | 14% | 4% |
| Crack after curing in N₂ at 250°C for 2 hours | absent | absent | present |
| Evaluation of adhesive force | 30 squares | 100 squares | 30 squares |
| Moisture resistance test | exfoliation at 24 hours | no exfoliation at 1,000 hours | exfoliation at several hours |
| Transmissivity (%) before moisture resistance test | 98 | 98 | 98 |
| Transmissivity (%) after moisture resistance test | unmeasurable due to exfoliation | 97 | unmeasurable due to exfoliation |

It is found from Table 3 that containing the crosslinkable monomer improves the breaking point elongation, has the thermal shock resistance in which no cracks and exfoliations are generated even at a high temperature, and improves the moisture resistance. It is also found that containing (CH₃O)₃-Si-(CH₂)₃-O-CO-C(CH₃)=CH₂ further improves the moisture resistance and the adhesive force.

### [Example 8]

A manufacturing method of a microplastic lens and an optical element for liquid crystal sheet polarizers

The differences between the microplastic lens and the optical element for liquid crystal sheet polarizers are only in type of the metal molds, and the manufacturing methods are the same.

1) A step of coating on a glass substrate and heating: the photosensitive resin composition obtained in Example 2 was added and diluted with 70% by mass of a solvent, NMP, and then coated on an alkali-free glass substrate made by Corning Inc. (10-cm square, thickness: 0.7 mm) using a spin coater under the conditions of 2,500 rpm and 30 sec. The coated composition was heated on a hot plate at 120°C for 5 min with the coated glass substrate surface being directed upward. The photosensitive resin composition after the drying and removal of NMP had a thickness of 1 µm.

2) A step of pressing a mold: five drops of the photosensitive resin composition obtained in Example 2 were dropped into a Ni metal-made mold for a microplastic lens or a Ni metal-made mold for an optical element for liquid crystal sheet polarizers with a dropper; and the resin-coated glass which had been subjected to the heating treatment and then cooled was pressed on and adhered to the dropped resin in the mold with the resin-coated glass surface being directed downward.

An exposure step: The photosensitive resin composition was overall irradiated from the glass substrate side with ultraviolet rays using no mask, using a proximity exposing apparatus, a mirror projection aligner, made by Canon Corp., in the state that the photosensitive resin composition was interposed between the glass substrate and the metal mold. The irradiation amount in i-line wavelength (365 nm) was 400 mJ/cm².

3) A step of separating the mold: after the ultraviolet curing, the metal mold was separated from the glass substrate.

4) A final heating step: the resultant glass substrate was heated in nitrogen at a temperature of 250°C for 2 hours using a curing oven.

### [Example 9]

A manufacturing method of a microplastic lens using a mask
1) A step of coating on a substrate and heating: the photosensitive resin composition obtained in Example 2 was added and diluted with 40% by mass of NMP, and then dropped on a silicon substrate, and coated thereon using a spin coater under the conditions of 2,500 rpm and 30 sec. The coated composition was heated on a hot plate at 120°C for 5 min with the coated silicon substrate surface being directed upward. The photosensitive resin composition after the drying and removal of NMP had a thickness of 6 µm.

2) A step of multiple exposure: three masks having circular patterns of a microplastic lens were previously prepared. Lens arrays (longitudinally and laterally each 5 lenses, 25 lenses in total) of patterns for negative-type resist of 2 µm, 4 µm and 6 µm in diameter as the dimensions on the silicon wafer were fabricated by CAD to make masks. The circular patterns were fabricated such that the smallest diameter was obtained by [the largest diameter÷the number of exposures=the smallest diameter]. Each mask had an alignment mark, and each lens pattern had a concentric circular pattern having a different diameter. Since the remaining-film saturated value after development etching was 3 µm, and the necessary lowest exposure level at this time was 90 mJ/cm², the ultraviolet exposure was performed by concentrically stacking the masks sequentially from the mask having the smallest concentric diameter of 2 µm in a constant light amount of [90÷3=30 mJ/cm²].

3) A developing step: development was performed by the rotary spray method. Cyclohexane was used as a developing solution, and the spray development was performed for 20 sec ;and rinsing was performed for 10 sec using isopropylalcohol as a rinsing solution.

4) A final heating step: heating was performed in nitrogen at 250°C for 2 hours using a curing oven.

### INDUSTRIAL APPLICABILITY

The organosiloxane composition of the present invention is preferably utilized for insulating materials of electronic components, for formation of surface protecting films, interlayer insulating films, alpha-ray shielding films and the like in semiconductor devices, and for semiconductor devices and the like mounting image sensors, micromachines or microactuators, and as a resin composition used for their formation.

## Claims

1. A polyorganosiloxane composition comprising the following components (a) to (c):
(a) 100 parts by mass of a polyorganosiloxane obtained by mixing and polymerizing at least one silanol compound represented by the general formula (1) shown below, at least one alkoxysilane compound represented by the general formula (2) shown below, and at least one catalyst , said catalyst selected from the group consisting of a metal alkoxide represented by the general formula (3) shown below, a metal alkoxide represented by the general formula (4) shown below, and Ba(OH)₂, without purposely adding water,
R₂Si(OH)₂ (1)
R'Si(OR")₃ (2)
where R is a group having 6 to 20 carbon atoms containing at least one aromatic group; R' is an organic group having 2 to 17 carbon atoms containing at least one group selected from the group consisting of an epoxy group and a carbon-carbon double bond group; and R" is a methyl group or an ethyl group,
M(OR"')₄ (3)
where M denotes any one of silicon, germanium, titanium and zirconium; and R"' is an alkyl group having 1 to 4 carbon atoms,
M'(OR"")₃ (4)
where M' denotes boron or aluminum; and R"" is an alkyl group having 1 to 4 carbon atoms;
(b) 0.1 to 20 parts by mass of a photopolymerization initiator; and
(c) 1 to 100 parts by mass of a compound, other than the component (a), having two or more photopolymerizable unsaturated bond groups.

2. The composition according to claim 1, **characterized by** further comprising (e) 0.1 to 20 parts by mass of at least one organosilicon compound selected from the group consisting of (CH₃O)₃-Si-(CH₂)₃-O-CO-C(CH₃)=CH₂, (CH₃O)₃-Si-(CH₂)₃-O-CO-CH=CH₂ and (CH₃O)₃-Si-(CH₂)₃-O-CH₂-C₂H₃O (the afore-mentioned C₂H₃O being an epoxy group) based on 100 parts by mass of the component (a).

3. The composition according to claim 1 or claim 2, wherein the catalyst is at least one metal alkoxide selected from the group consisting of a metal alkoxide represented by the general formula (3) and a metal alkoxide represented by the general formula (4).

4. The composition according to any one of claims 1 to 3, **characterized in that** the polyorganosiloxane (a) is obtained by mixing the silanol compound, the alkoxysilane compound, the catalyst, potassium hydroxide and sodium hydroxide, and polymerizing the mixture without purposely adding water.

5. The composition according to any one of claims 1 to 4, further comprising 50 to 200 parts by mass of (d) a silicone resin based on 100 parts by mass of the component (a).

6. A process for manufacturing a microplastic lens or an optical element for a liquid crystal sheet polarizer, **characterized by** conducting the sequential steps of:
coating a composition according to any one of claims 1 to 5 on a glass substrate, and heating the coated substrate at 50 to 150°C for 1 to 30 min to obtain a composition-adhered glass substrate;
pressing an opening portion of a mold for moldings in which a separately prepared composition according to any one of claims 1 to 5 is filled, against the composition-adhered surface of the composition-adhered glass substrate;
exposing the resultant pressed substrate from the glass substrate side to light;
stripping the mold for moldings from the glass substrate; and
heating the resultant stripped substrate at a temperature of 150°C to 250°C for 0.5 hour to 2 hours.

7. A process for manufacturing a microplastic lens, **characterized by** conducting the sequential steps of:
coating a composition according to any one of claims 1 to 5 on a glass substrate or a silicon substrate, and heating the coated substrate at 50 to 150°C for 1 to 30 min to obtain a composition-adhered glass substrate or silicon substrate;
exposing plural times the resultant composition-adhered substrate to ultraviolet rays using a plurality of masks composed of circular patterns of a microplastic lens, each mask having an alignment mark and each lens pattern having a concentric circular pattern of a different diameter, and through every mask sequentially starting from a mask of the smallest circular diameter at a constant exposure level of a remaining-film saturated minimum exposure level after development etching divided by the number of the masks;
developing the resultant substrate after the exposure; and
heating the resultant substrate at a temperature of 150°C to 250°C for 0.5 hour to 2 hours after the development.

8. A method of forming a polyorganosiloxane film, **characterized by** coating a composition according to any one of claims 1 to 5 onto a base.

9. A polyorganosiloxane cured film, **characterized by** curing a polyorganosiloxane film obtained by a method according to claim 8 by at least one method selected from the group consisting of irradiation with active light ray and heating.

10. A process for forming a polyorganosiloxane cured relief pattern, comprising the steps of:
forming a polyorganosiloxane film on a base having a metal interconnection or a base having no metal interconnection by a method according to claim 8;
irradiating the film with active light ray through a patterning mask to photocure an exposed portion;
removing an uncured portion of the film using a developing solution; and
heating the resultant film together with the base.

11. A polyorganosiloxane cured relief pattern, obtained by a method according to claim 10.

12. A semiconductor device comprising a cured film according to claim 9.

13. A semiconductor device comprising a cured relief pattern according to claim 11.

14. A semiconductor device comprising:
a microstructure formed on a crystal substrate on which an integrated circuit is formed;
a packaging material to cover the microstructure; and
a spacer material to support the packaging material on the microstructure,
**characterized in that** the spacer material is a cured film according to claim 9.

15. The semiconductor device according to claim 14, **characterized in that** the integrated circuit comprises a photodiode.

16. The semiconductor device according to claim 14 or claim 15, **characterized in that** the microstructure is a microlens.

17. A process for manufacturing a semiconductor device according to any one of claims 14 to 16, comprising the steps of:
forming a polyorganosiloxane film on a microstructure directly or through a thin film layer;
irradiating the film with active light ray through a patterning mask to photocure an exposed portion;
removing an uncured portion of the film using a developing solution; and
heating the film together with a base.
